# EUROPEAN PATENT APPLICATION

(11) **EP 4 723 810 A1**
(43) Date of publication of application: **08.04.2026**
(21) Application number: 24822677.1
(22) Date of filing: 11.06.2024
(51) Int. Cl.: H05K 1/02, H05K 1/18, H05K 3/30, H05K 1/14

(54) **SINGLE BOARD, METHOD FOR ASSEMBLING SINGLE BOARD, AND COMMUNICATION DEVICE**

(30) Priority: 15.06.2023 CN 202310717140
(71) Applicant: Huawei Technologies Co., Ltd., Shenzhen, Guangdong 518129 (CN)
(72) Inventor: TENG, Qiangyuan, Shenzhen, Guangdong 518129 (CN); GUO, Qiulai, Shenzhen, Guangdong 518129 (CN); GENG, Baoming, Shenzhen, Guangdong 518129 (CN); CHI, Moyuan, Shenzhen, Guangdong 518129 (CN); WANG, Xuecheng, Shenzhen, Guangdong 518129 (CN); ZHAO, Yanhui, Shenzhen, Guangdong 518129 (CN); JIAO, Zelong, Shenzhen, Guangdong 518129 (CN)
(74) Representative: Maiwald GmbH
(86) International application number: PCT/CN2024/098372
(87) International publication number: WO 2024/255727

(57) **Abstract**

The present disclosure provides a board, a board assembly method, and a communication device, and belongs to the field of communication technologies. The board includes a main chip module, a basic configuration, an interface component, and a first circuit board. The main chip module includes a main chip and a second circuit board. The main chip is located on a surface of the second circuit board. There is at least one first circuit board. The basic configuration and the interface component are located on a surface of the at least one first circuit board. The main chip is separately electrically connected to the basic configuration and the interface component. According to the present disclosure, resource waste can be reduced, and costs of the board can be reduced.

## Description

This application claims priority to Chinese Patent Application No. 202310717140.X, filed on June 15, 2023 and entitled "BOARD, BOARD ASSEMBLY METHOD, AND COMMUNICATION DEVICE", which is incorporated herein by reference in its entirety.

### TECHNICAL FIELD

The present disclosure relates to the field of communication technologies, and in particular, to a board, a board assembly method, and a communication device.

### BACKGROUND

A communication device, for example, a router or a switch, structurally includes a plurality of boards such as a service board and a switch board. The service board is mainly responsible for receiving and sending a service signal, and the switch board is mainly responsible for forwarding a service signal between different service boards.

Although the boards have different functions, the board usually structurally includes a main board, a main chip, a basic configuration (for example, including a central processing unit (central processing unit, CPU) system, a clock system, and a power system), an interface component, and the like. The main board is a printed circuit board (printed circuit board, PCB). The main chip is related to a type of the board. For example, a main chip of a service board may be a network processor (network processor, NP) chip or a packet processor (packet processor, PP) chip, and a main chip of a switch board is a forwarding engine (forwarding engine, FE) chip.

In terms of layout of the foregoing components of the board, the main chip, the basic configuration, and the interface component are all located on a surface of the main board, and these components are interconnected through cabling on the main board. Such a layout manner of the board leads to high costs.

### SUMMARY

The present disclosure provides a board, a board assembly method, and a communication device, to resolve a problem of high costs of a board in a related technology. The technical solutions are as follows.

According to a first aspect of the present disclosure, a board is provided, including a main chip module, a basic configuration, an interface component, and a first circuit board.

The main chip module includes a main chip and a second circuit board, and the main chip is located on a surface of the second circuit board.

There is at least one first circuit board, and the basic configuration and the interface component are located on a surface of the at least one first circuit board.

The main chip is separately electrically connected to the basic configuration and the interface component.

In the solution shown in the present disclosure, the main chip is located on the surface of the second circuit board, and the basic configuration and the interface component of the board are located on the surface of the at least one first circuit board. It can be learned that the main chip running at a high speed and the basic configuration and the interface component that run at a low speed are not located on a same circuit board. In this way, the first circuit board only needs to meet a running requirement of the basic configuration and the interface component, and does not need to meet a running requirement of the main chip. The second circuit board is configured to meet the running requirement of the main chip. Therefore, both the first circuit board and the second circuit board can play respective maximum values, thereby reducing resource waste.

In addition, the second circuit board is processed by using a high-performance board material that is adapted to the main chip, and the first circuit board is processed by using a board material that is adapted to the basic configuration and the interface component. In this way, there is no need to use the high-performance board material to process all the circuit boards. Therefore, board material costs of the circuit boards can be reduced, and costs of the board can be reduced.

In a possible implementation, the second circuit board is electrically connected to the at least one first circuit board.

In the solution shown in the present disclosure, an electrical connection between the main chip and the basic configuration may be implemented through an electrical connection between the second circuit board on which the main chip is located and the first circuit board on which the basic configuration is located. An electrical connection between the main chip and the interface component may also be implemented through an electrical connection between the second circuit board on which the main chip is located and the first circuit board on which the interface component is located. In this way, cable intersection can be avoided, and cable arrangement inside the board is simplified.

In a possible implementation, an electrical connection manner between the second circuit board and the first circuit board includes at least one of a connection by using a cable, a connection by using a flexible printed circuit, a connection by using a pluggable connector, and a connection by using an adapter board.

The pluggable connector may be a blind-mating connector, a pogopin pogopin connector, or a crimp connector.

In the solution shown in the present disclosure, the first circuit board and the second circuit board may be electrically connected by using the cable, for example, a copper cable, may be electrically connected by using the flexible printed circuit, may be electrically connected by using the adapter board, or may be electrically connected by using the pluggable connector. The second circuit board may be further located on a surface of the first circuit board, and a lower surface of the second circuit board is crimped on an upper surface of the first circuit board, to implement an electrical connection between the first circuit board and the second circuit board.

In the solution shown in the present disclosure, a plurality of electrical connections are implemented between the first circuit board and the second circuit board. In this case, a plurality of electrical connection manners may be the same and be one of the foregoing electrical connection manners, or a plurality of electrical connection manners may be different and be two or more of the foregoing electrical connection manners.

It can be learned that the electrical connection manner between the first circuit board and the second circuit board is flexible, and the electrical connection manner has strong compatibility. Further, an electrical connection manner between the main chip and the basic configuration and an electrical connection manner between the main chip and the interface component are flexible, and have strong compatibility.

In a possible implementation, there is one first circuit board, and the basic configuration and the interface component are located on a surface of a same first circuit board.

In the solution shown in the present disclosure, the basic configuration may be located on the surface of the first circuit board, and the interface component may be directly arranged in the board. Alternatively, the basic configuration and an external interface component are arranged on the surface of the same first circuit board, and an internal interface component is directly arranged in the board.

In a possible implementation, there are a plurality of first circuit boards, and the basic configuration and the interface component are located on surfaces of different first circuit boards.

In the solution shown in the present disclosure, the basic configuration and the interface component are arranged on the surfaces of the different first circuit boards. For example, the basic configuration and the interface component are located on different sides of the main chip module. In this case, the basic configuration may be located on a small-sized first circuit board, an internal interface component is arranged on a small-sized first circuit board, and an external interface component is arranged on another small-sized first circuit board. Compared with using a large-sized first circuit board to accommodate the basic configuration and the interface component at different locations, a board material size of the first circuit board can be reduced, thereby controlling board material costs of the circuit board.

In a possible implementation, the interface component includes an external interface component and an internal interface component.

There are at least two first circuit boards, the external interface component is located on a surface of one of the first circuit boards, and the internal interface component is located on a surface of the other first circuit board.

In the solution shown in the present disclosure, the internal interface component and the external interface component are located on two opposite sides of the main chip module. In this layout, the internal interface component is arranged on one of the first circuit boards, and the external interface component is arranged on the other first circuit board. Compared with using a large-sized first circuit board to accommodate the internal structural component and the external structural component that are far away from each other, a board material size of the first circuit board can be reduced, thereby controlling board material costs of the circuit board.

In a possible implementation, the second circuit board of the main chip module is fastened to a housing of the board.

In the solution shown in the present disclosure, the main chip module may be directly fastened to the housing of the board by using the second circuit board of the main chip module, for example, may be directly fastened to a bottom plate or an upper cover of the housing.

In a possible implementation, the second circuit board of the main chip module is underslung-mounted on a lower surface of a heat sink of the board, and the heat sink is fastened to a housing of the board.

In the solution shown in the present disclosure, the main chip module may be underslung-mounted on the lower surface of the heat sink by using the second circuit board of the main chip module.

In a possible implementation, the first circuit board is fastened to a housing of the board, and the second circuit board of the main chip module is fastened to the first circuit board by using a structural part.

In the solution shown in the present disclosure, the second circuit board of the main chip module is fastened to the first circuit board by using the structural part.

It can be learned that the main chip module may be fastened to the housing of the board in a plurality of manners, thereby enhancing assembly flexibility of the main chip module in the board.

According to a second aspect of the present disclosure, a board assembly method is provided, where the board is the board according to the first aspect. The method includes:
fastening the basic configuration and the interface component to the surface of the at least one first circuit board;
fastening the main chip module and the at least one first circuit board to the housing of the board; and
separately electrically connecting the main chip of the main chip module to the basic configuration and the interface component.

In the solution shown in the present disclosure, the main chip is located on the surface of the second circuit board, and the basic configuration and the interface component of the board are located on the surface of the at least one first circuit board. It can be learned that the main chip running at a high speed and the basic configuration and the interface component that run at a low speed are not located on a same circuit board. In this way, the first circuit board only needs to meet a running requirement of the basic configuration and the interface component, and does not need to meet a running requirement of the main chip. The second circuit board is configured to meet the running requirement of the main chip. Therefore, both the first circuit board and the second circuit board can play respective maximum values, thereby reducing resource waste.

In addition, the second circuit board is processed by using a high-performance board material that is adapted to the main chip, and the first circuit board is processed by using a board material that is adapted to the basic configuration and the interface component. In this way, there is no need to use the high-performance board material to process all the circuit boards. Therefore, board material costs of the circuit boards can be reduced, and costs of the board can be reduced.

In a possible implementation, fastening the main chip module to the housing of the board includes fastening the second circuit board of the main chip module to the housing of the board.

In a possible implementation, fastening the second circuit board of the main chip module to the housing of the board includes:
fastening the second circuit board of the main chip module to the lower surface of the heat sink, where the main chip of the main chip module is located between the heat sink and the second circuit board; and
fastening the heat sink to the housing of the board.

In a possible implementation, fastening the second circuit board of the main chip module and the at least one first circuit board to the housing of the board includes:
fastening the second circuit board of the main chip module to the at least one first circuit board by using the structural part; and
fastening the at least one first circuit board to the housing of the board.

In the solution shown in the present disclosure, the main chip module may be fastened to the housing of the board in a plurality of manners, thereby enhancing assembly flexibility of the main chip module in the board.

According to a third aspect of the present disclosure, a communication device is provided. The communication device includes the board according to the second aspect.

In the solution shown in the present disclosure, the main chip is located on the surface of the second circuit board, and the basic configuration and the interface component of the board are located on the surface of the at least one first circuit board. It can be learned that the main chip running at a high speed and the basic configuration and the interface component that run at a low speed are not located on a same circuit board. In this way, the first circuit board only needs to meet a running requirement of the basic configuration and the interface component, and does not need to meet a running requirement of the main chip. The second circuit board is configured to meet the running requirement of the main chip. Therefore, both the first circuit board and the second circuit board can play respective maximum values, thereby reducing resource waste.

In addition, the second circuit board is processed by using a high-performance board material that is adapted to the main chip, and the first circuit board is processed by using a board material that is adapted to the basic configuration and the interface component. In this way, there is no need to use the high-performance board material to process all the circuit boards. Therefore, board material costs of the circuit boards can be reduced, and costs of the board can be reduced.

### BRIEF DESCRIPTION OF DRAWINGS

FIG. 1 is a diagram of an architecture of a communication device according to the present disclosure;
FIG. 2 is a diagram of an architecture of a communication device according to the present disclosure;
FIG. 3 is a diagram of a communication device according to the present disclosure;
FIG. 4 is a diagram of a board according to the present disclosure;
FIG. 5 is a diagram of a plurality of main chip modules according to the present disclosure;
FIG. 6 is a diagram showing that a basic configuration and an internal interface component are located on a surface of a same first circuit board and an external interface component is located on a surface of a different first circuit board according to the present disclosure;
FIG. 7 is a diagram showing that a basic configuration and an external interface component are located on surfaces of different first circuit boards according to the present disclosure;
FIG. 8 is a diagram showing that a basic configuration and an internal interface component are located on surfaces of different first circuit boards according to the present disclosure;
FIG. 9 is a diagram showing that a basic configuration, an internal interface component, and an external interface component are located on surfaces of different first circuit boards according to the present disclosure;
FIG. 10 is a diagram showing that a basic configuration and an interface component are located on a surface of a same first circuit board according to the present disclosure;
FIG. 11 is a diagram of a board according to the present disclosure;
FIG. 12 is a diagram of a board according to the present disclosure;
FIG. 13 is a diagram of an electrical connection between a first circuit board and a second circuit board according to the present disclosure;
FIG. 14 is a diagram of an electrical connection between a first circuit board and a second circuit board according to the present disclosure;
FIG. 15 is a diagram of an electrical connection between a first circuit board and a second circuit board according to the present disclosure;
FIG. 16 is a diagram of a first surface of a second circuit board of a main chip module according to the present disclosure;
FIG. 17 is a diagram of a second surface of a second circuit board of a main chip module according to the present disclosure;
FIG. 18 is a diagram showing that a second circuit board of a main chip module is directly fastened in a housing according to the present disclosure;
FIG. 19 is a diagram showing that a second circuit board of a main chip module is underslung-mounted on a lower surface of a heat sink according to the present disclosure; and
FIG. 20 is a diagram showing that a second circuit board of a main chip module is fastened to a first circuit board by using a structural part according to the present disclosure.

### Reference numerals:

1. main chip module; 11. main chip; 12. second circuit board; 13. power supply module;
2. basic configuration; 21. CPU system; 22. clock system; 23. power system;
3. interface component; 31. internal interface component; 32. external interface component;
4. first circuit board; 5. housing; 6. heat sink; 7. structural part; and 8. adapter board.

### DESCRIPTION OF EMBODIMENTS

Although the present disclosure is described with reference to some embodiments, this does not mean that features of this application are limited only to the implementations. On the contrary, an objective of describing this application with reference to implementations is to cover another option or modification that may be derived based on claims of the present disclosure. To provide an in-depth understanding of the present disclosure, the following descriptions include a plurality of specific details. The present disclosure may alternatively be implemented without using these details. In addition, to avoid confusing or blurring a focus of the present disclosure, some specific details are omitted from the descriptions. It should be noted that embodiments in the present disclosure and the features in embodiments may be mutually combined in the case of no conflict.

Reference to "an embodiment", "some embodiments", or the like described in embodiments of the present disclosure indicates that one or more embodiments of the present disclosure include a specific feature, structure, or characteristic described with reference to embodiments. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner.

In embodiments of the present disclosure, the terms "first", "second", "third", and "fourth" are merely intended for a purpose of description, and shall not be understood as an indication or implication of relative importance or an implicit indication of a quantity of indicated technical features. Therefore, a feature defined by "first", "second", "third", or "fourth" may explicitly or implicitly include one or more of the features.

In embodiments of the present disclosure, terms "include", "comprise", "have", and their variants all mean "include but are not limited to", unless otherwise specifically emphasized in another manner.

In embodiments of the present disclosure, unless otherwise specified and limited, the terms "mount" and "connect" should be understood in a broad sense. For example, a "connection" may be a detachable connection, or a non-detachable connection; and may be a direct connection, or may be an indirect connection through an intermediate medium.

"And/Or" in embodiments of the present disclosure describes only an association relationship for describing associated objects and represents that three relationships may exist. For example, A and/or B may represent the following three cases: Only A exists, both A and B exist, and only B exists. In addition, the character "/" in this specification generally indicates an "or" relationship between the associated objects.

The orientation terms mentioned in embodiments of the present disclosure, for example, "upper", "lower", "left", "right", "internal", and "external", are merely directions based on the accompanying drawings. Therefore, the orientation terms are used to better and more clearly describe and understand embodiments of the present disclosure, instead of indicating or implying that a specified apparatus or element should have a specific orientation or be constructed and operated in a specific orientation. Therefore, this cannot be understood as a limitation on embodiments of the present disclosure.

Embodiments of the present disclosure relate to a board. The board may also be referred to as a board card. The board may be used in a communication device. The communication device may be specifically a routing device, a switching device, another device including the board, or the like.

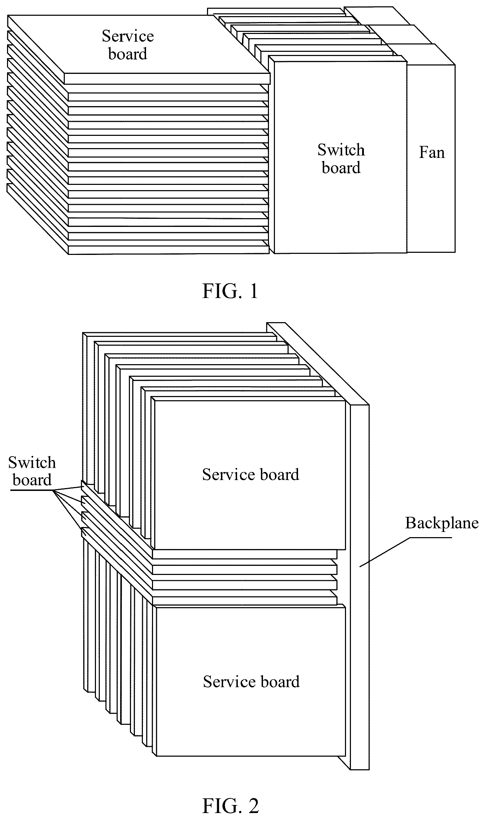

The communication device may be a frame-shaped device, or may be a box-shaped device. FIG. 1 and FIG. 2 are diagrams of architectures of a frame-shaped communication device. FIG. 1 is a diagram of a communication device of an orthogonal architecture without a backplane, and FIG. 2 is a diagram of a communication device of a non-orthogonal architecture with a backplane. The communication device mainly includes a frame (not shown in the figure), one or more main control boards (not shown in the figure), one or more service boards, one or more switch boards, a fan for heat dissipation, a power supply module (not shown in the figure), and the like.

The main control board is configured to manage the switch board and the service board. The service board is configured to be responsible for receiving and sending data. Specifically, any service board has one or more service chips, and is responsible for receiving and sending data by using the service chip. In some embodiments, the communication device includes 16 service boards. The switch board is configured to forward data. Specifically, any switch board has one or more switch chips, and is responsible for forwarding data between different service chips by using the switch chip. In some embodiments, the communication device includes eight switch boards.

The following describes the communication device in more detail by using an example.

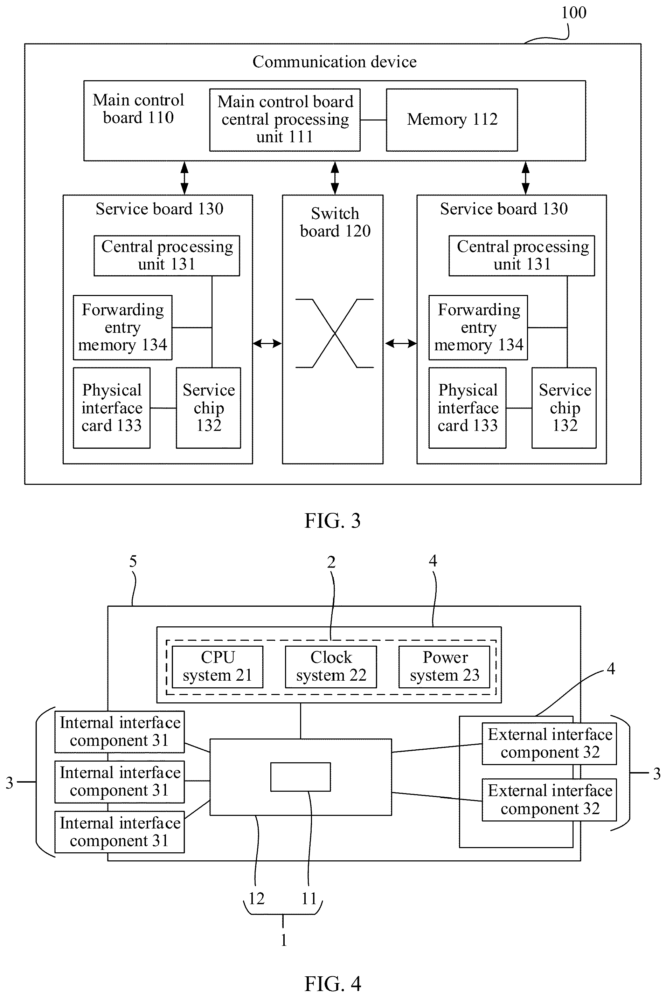

FIG. 3 is a diagram of logic of a communication device 100. The communication device 100 includes a main control board 110, a switch board 120, and a service board 130.

The main control board 110 is also referred to as a main processing unit (main processing unit, MPU) or a route processing card (route processing card), and is configured to control and manage components in the communication device 100, including routing computation, device management, device maintenance, and a protocol processing function. As shown in FIG. 3, the main control board 110 includes a main control board central processing unit 111 and a memory 112.

The switch board 120 may also be referred to as a switch fabric unit (switch fabric unit, SFU) or a fabric card. When the communication device 100 has a plurality of service boards 130, the switch board 120 is configured to complete data exchange between the service boards 130. For example, two service boards 130 in FIG. 3 may communicate with each other by using the switch board 120. The switch board 120 includes a switch chip, and the switch chip may be specifically a forwarding engine (forwarding engine, FE) chip.

The service board 130 is also referred to as an interface board, a line interface unit card (line processing unit, LPU), or a line card (line card). The service board 130 is configured to provide various service interfaces and implement data packet forwarding. The service interfaces include but are not limited to an Ethernet interface, a POS (Packet over SONET/SDH) interface, and the like. The Ethernet interface is, for example, a flexible Ethernet service interface (flexible Ethernet clients, FlexE Clients). As shown in FIG. 3, the service board 130 includes a central processing unit 131, a service chip 132 (the service chip may also be referred to as a network chip), a forwarding entry memory 134, and a physical interface card (physical interface card, PIC) 133. The service chip 132 may be specifically a network processor (network processor, NP) chip or a packet processor (packet processor, PP) chip.

The central processing unit 131 on the service board 130 is configured to control and manage the service board 130 and communicate with the main control board central processing unit 111 on the main control board 110.

The service chip 132 is configured to implement packet forwarding and processing. A form of the service chip 132 may be a forwarding chip. Specifically, the service chip 132 is configured to forward a received packet based on a forwarding table stored in the forwarding entry memory 134. If a destination address of the packet is an address of the communication device 100, the packet is sent to a CPU (for example, the main control board central processing unit 111) for processing. If a destination address of the packet is not an address of the communication device 100, a next hop and an egress interface that correspond to the destination address are found in a forwarding table based on the destination address, and the packet is forwarded to the egress interface corresponding to the destination address. Processing of an uplink packet includes processing an inbound interface of the packet and searching for the forwarding table. Processing of a downlink packet includes searching for the forwarding table and the like.

The physical interface card 133 is configured to implement a physical layer interconnection function. Original traffic enters the service board 130 from the physical interface card 133, and a processed packet is sent from the physical interface card 133. The physical interface card 133 is also referred to as a subcard, may be mounted on the service board 130, and is responsible for converting an optical/electrical signal into a packet, performing legitimacy check on the packet, and forwarding the packet to the service chip 132 for processing. In some embodiments, the central processing unit may also perform a function of the service chip 132, for example, implement software forwarding based on a general-purpose CPU, so that the physical interface card 133 does not need the service chip 132.

In some examples, the communication device 100 includes a plurality of service boards 130.

The main control board 110 is coupled to the service boards 130. For example, the main control board 110, the two service boards 130, and the switch board 120 are connected to a system backplane by using a system bus to implement interworking. In some examples, an inter-process communication (inter-process communication, IPC) protocol channel is established between the main control board 110 and the service board 130, and the main control board 110 and the service board 130 communicate with each other through the IPC channel.

Logically, the communication device 100 includes a control plane and a forwarding plane. The control plane includes the main control board 110 and the central processing unit 131. The forwarding plane includes various components for forwarding, for example, the forwarding entry memory 134, the physical interface card 133, and the network chip 132. The control plane implements functions of a router, generating the forwarding table, processing signaling and a protocol packet, configuring and maintaining a device status, and the like. The control plane delivers the generated forwarding table to the forwarding plane. On the forwarding plane, the service chip 132 performs, based on the forwarding table delivered by the control plane, table lookup and forwarding on a packet received by the physical interface card 133. The forwarding table delivered by the control plane may be stored in the forwarding entry memory 134. In some embodiments, the control plane and the forwarding plane may be completely separate and not on a same device.

In some embodiments, there may be one or more main control boards 110, when there are a plurality of main control boards 110, the main control boards 110 may include a primary main control board and a backup main control board. There may be one or more service boards 130. A larger quantity of service boards 130 provided by the communication device generally indicates a stronger data processing capability of the communication device. There may also be one or more physical interface cards on the service board 130. There may also be one or more switch boards 120, and when there are a plurality of switch boards 120, load sharing and redundancy backup may be implemented together. In a distributed forwarding architecture, the communication device may have at least one switch board 120, and implements data exchange between a plurality of service boards 130 by using the switch board 120, to provide a large-capacity data exchange and processing capability.

The control board, the service board, and the switch board each are one type of board. Although these boards have different functions, the boards each mainly include a main board, a main chip, a basic configuration, an interface component, and the like in structure. The main board is a PCB. For the main chip, for example, a main chip of the service board is a service chip or a main chip of the switch board is a switch chip. The basic configuration, for example, includes a CPU system, a clock system, a power system, and the like. The interface component may be, for example, an external interface component (for example, an optical cage) or an internal interface component (for example, a high-speed connector), or may include an external interface component and an internal interface component.

In terms of a layout of the foregoing components of the board, the main chip, the basic configuration, and the interface component are all mounted on a same main board. The main chip is electrically connected to the basic configuration and the interface component through cabling on the main board. However, if all the components are arranged on the same main board, at least the following problems exist:

First, performance of the main board needs to be adapted to performance of the main chip. For example, a high-performance main chip needs to be configured with a high-performance main board, and other components on the main board, such as the basic configuration and the interface component, do not need such a high-performance main board. It can be learned that the entire main board requires a high-performance board material, which causes resource waste and increases board material costs of the main board.

Then, when the board needs to be configured with a plurality of main chips, a main board that can be assembled with the main chips further needs to be developed, which increases board material costs of the main board and increases development costs of the main board.

An embodiment provides a board. In the board, a main chip of the board is separated and is configured with a circuit board adapted to the main chip, and does not share the circuit board with a basic configuration and an interface component, thereby reducing board material costs of the circuit board, and saving costs of the board.

As shown in FIG. 4, the board includes a main chip module 1, a basic configuration 2, an interface component 3, and a first circuit board 4. The main chip module 1 includes a main chip 11 and a second circuit board 12, and the main chip 11 is located on a surface of the second circuit board 12. There is at least one first circuit board 4, and the basic configuration 2 and the interface component 3 are located on a surface of the at least one first circuit board 4. The main chip 11 is separately electrically connected to the basic configuration 2 and the interface component 3.

The main chip 11 is located on the surface of the second circuit board 12, and the basic configuration 2 and the interface component 3 of the board are located on the surface of the at least one first circuit board 4. It can be learned that the main chip 11 running at a high speed and the basic configuration 2 and the interface component 3 that run at a low speed are not located on a same circuit board. In this way, the first circuit board 4 only needs to meet a running requirement of the basic configuration 2 and the interface component 3, and does not need to meet a running requirement of the main chip 11. The second circuit board 12 is configured to meet the running requirement of the main chip 11. Therefore, both the first circuit board 4 and the second circuit board 12 can play respective maximum values, thereby reducing resource waste.

In addition, the second circuit board 12 is processed by using a high-performance board material that is adapted to the main chip 11, and the first circuit board 4 is processed by using a board material that is adapted to the basic configuration 2 and the interface component 3. In this way, there is no need to use the high-performance board material to process all the circuit boards. Therefore, board material costs of the circuit boards can be reduced, and costs of the board can be reduced.

The following describes features of the components on the board in detail.

The main chip 11 is a chip that implements a main function of the board, and a specific type of the main chip 11 is related to a type of the board. For example, if the board is a service board, the main chip 11 may be a service chip, and may be specifically a network processor (network processor, NP) chip or a packet processor (packet processor, PP) chip. If the board is a switch board, the main chip 11 may be a switch chip, and may be specifically a forwarding engine (forwarding engine, FE) chip.

In an example, the second circuit board 12 is adapted to the main chip 11. For example, the second circuit board 12 is adapted to the main chip 11 in size specification and performance, and the main chip 11 is located on the surface of the second circuit board 12.

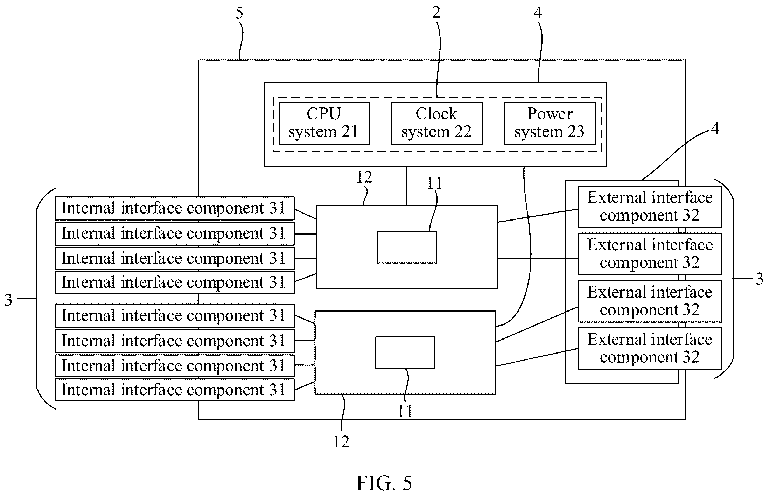

In an example, there may be one or more main chip modules 1. For example, as shown in FIG. 4, there is one main chip module 1, and as shown in FIG. 5, there are two main chip modules 1. Certainly, there may alternatively be more main chip modules 1. In a solution in which there are a plurality of main chip modules 1, each of the main chip modules 1 includes a main chip 11 and a second circuit board 12, and the main chip 11 is located on a surface of the second circuit board 12.

It should be noted that, in the solution in which there are a plurality of main chip modules 1, the plurality of main chip modules 1 may be the same or may be different. "Two main chip modules 1 are different" may be that types of included main chips 11 are different. For example, a main chip 11 of one of the main chip modules 1 is an NP chip, and a main chip 11 of the other main chip module 1 is a PP chip. "Two main chip modules 1 are different" may alternatively be that types of included main chips 11 are the same, but sizes, capacities, or processing capabilities of the included main chips 11 are different.

In an example, there are the following several solutions for a quantity of main chips 11 and a quantity of second circuit boards 12 that are included in each main chip module 1.

A solution may be as follows: The main chip module 1 includes one main chip 11 and one second circuit board 12. The main chip 11 is located on a surface of the second circuit board 12. When the main chip module 1 in which the main chip 11 is in one-to-one correspondence with the second circuit board 12 is used in the board, if the board needs to be configured with a plurality of main chips 11, a plurality of main chip modules 1 may be assembled in the board.

Another solution may be as follows: The main chip module 1 may alternatively include one second circuit board 12 and a plurality of main chips 11, and the plurality of main chips 11 are located on a surface of a same second circuit board 12. When the main chip module 1 in which the plurality of main chips 11 correspond to one second circuit board 12 is used in the board, if the board needs to be configured with a plurality of chips 11, one or more main chip modules 1 may be assembled in the board.

Another solution may be as follows: There may be a plurality of types of main chip modules 1. A quantity of types of the main chip modules 1 is determined based on a quantity of main chips 11 usually included in the board. For example, the board usually includes one, two, or four main chips 11. In this case, there may be three types of main chip modules 1. In one type of main chip module 1, a main chip 11 and a second circuit board 12 are in one-to-one correspondence. In another type of main chip module 1, two main chips 11 correspond to one second circuit board 12, and the two main chips 11 are located on a surface of the second circuit board 12. In another type of main chip module 1, four main chips 11 correspond to one second circuit board 12, and the four main chips 11 are located on a surface of the second circuit board 12. In this way, during subsequent board assembly, a corresponding main chip module 1 may be selected to be assembled in the board according to a requirement of the board for the main chip 11.

For example, if the board needs to be configured with two main chips 11, a main chip module 1 in which two main chips 11 are located on one second circuit board 12 may be assembled in the board. Alternatively, two main chip modules 1 may be assembled in the board, and each of the main chip modules 1 includes one main chip 11 and one second circuit board 12.

A quantity of main chips 11 included in the main chip module 1 is not specifically limited in this embodiment. For ease of description, an example in which the main chip module 1 includes one main chip 11 and one second circuit board 12 may be used.

The foregoing describes the main chip module 1, and the following describes the basic configuration 2 and the interface component 3 of the board, where the basic configuration 2 is a basic component required for normal operating of the board. For example, as shown in FIG. 4, the basic configuration 2 may include a CPU system 21, a clock system 22, and a power system 23. Certainly, the basic configuration 2 further includes some other components, such as a heat dissipation component, which are not described in detail herein.

In an example, as shown in FIG. 4, the interface component 3 may include an internal interface component 31 and an external interface component 32. Usually, there are a plurality of internal interface components 31 and a plurality of external interface components 32. The internal interface component 31 is configured to be connected to another board in a communication device in which the board is located, and the external interface component 32 is configured to be connected to another communication device other than the communication device in which the board is located.

The internal interface component 31 may be a high-speed connector, and the external interface component 32 may be an optical cage.

For example, if the board is a service board of a frame-shaped communication device, the internal interface component 31 of the service board is configured to be connected to a switch board of the communication device. The external interface component 32 of the service board is configured to be connected to another communication device. One end of an optical cable is connected to the external interface component 32, and the other end of the optical cable is connected to the external interface component 32 of the another communication device. A connection between the optical cable and the communication device is implemented by using an optical module. For example, an electrical interface of the optical module is inserted into the external interface component 32 of the communication device, and the optical cable is inserted into an optical interface of the optical module.

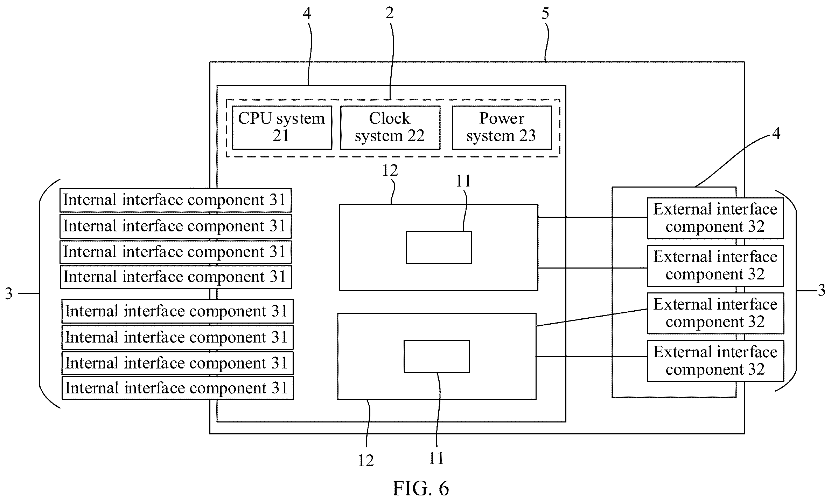

In another example, as shown in FIG. 6, the interface component 3 may alternatively include only an external interface component 32, and does not include an internal interface component 31. For example, a box-shaped communication device usually includes a plurality of external interface components 32.

In this embodiment, whether the interface component 3 includes a plurality of external interface components 32 or includes a plurality of internal interface components 31 and a plurality of external interface components 32 is not specifically limited, and may be flexibly designed according to an application scenario of the communication device.

In an example, there is at least one first circuit board 4, and the basic configuration 2 and the interface component 3 are located on a surface of the at least one first circuit board 4.

For example, as shown in FIG. 4 and FIG. 5, there are two first circuit boards 4, the basic configuration 2 is located on a surface of one of the first circuit boards 4, the external interface component 32 in the interface component 3 is located on a surface of the other first circuit board 4, and the internal interface component 31 of the interface component 3 is not arranged on the first circuit boards 4, but is directly assembled in the board.

For another example, as shown in FIG. 6, there are two first circuit boards 4, the basic configuration 2 and the internal interface component 31 are located on a surface of a same first circuit board 4, and the external interface component 32 is located on a surface of the other first circuit board 4.

Certainly, in the solution in which there are two first circuit boards 4, the basic configuration 2 and the external interface component 32 may alternatively be located on a surface of a same first circuit board 4, and the internal interface component 31 is located on a surface of the other first circuit board 4.

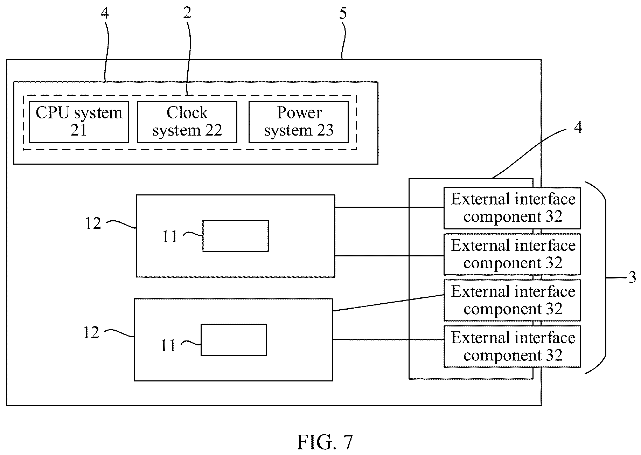

For another example, as shown in FIG. 7, there are two first circuit boards 4, and the basic configuration 2 is located on a surface of one of the first circuit boards 4. The interface component 3 includes an external interface component 32, but does not include an internal interface component 31. In this case, the external interface component 32 is located on a surface of the other first circuit board 4.

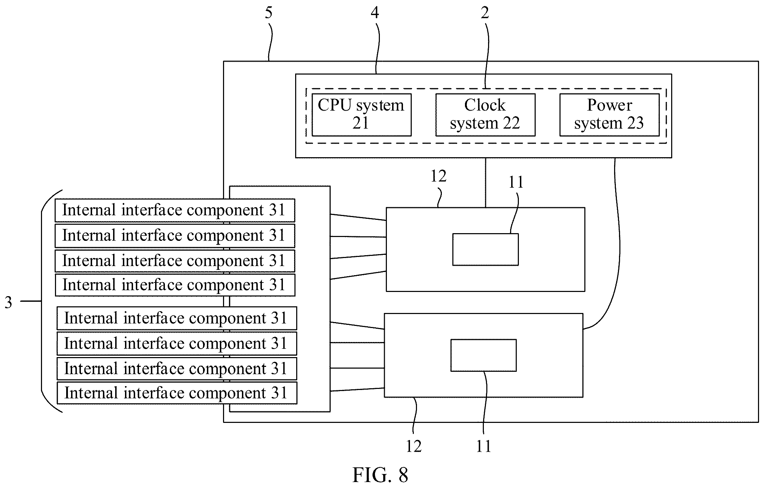

For another example, as shown in FIG. 8, there are two first circuit boards 4, and the basic configuration 2 is located on a surface of one of the first circuit boards 4. The interface component 3 includes an internal interface component 31, but does not include an external interface component. In this case, the internal interface component 31 is located on a surface of the other first circuit board 4.

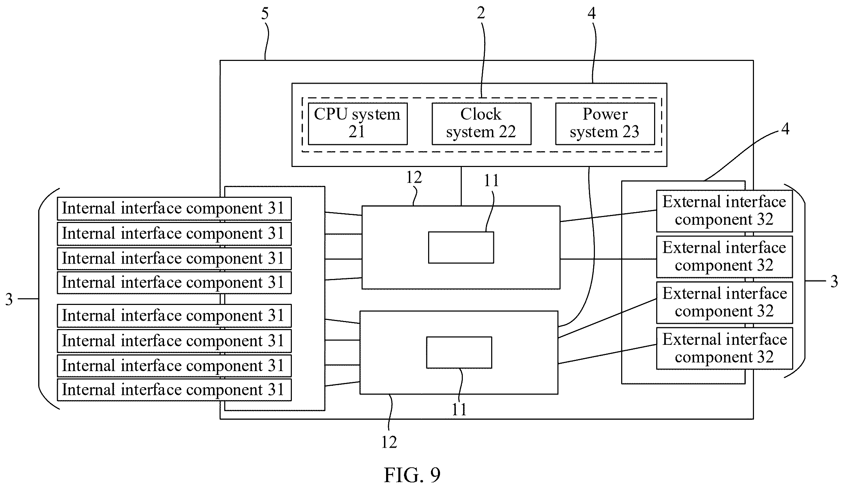

For another example, as shown in FIG. 9, there are three first circuit boards 4, the basic configuration 2 is located on a surface of one of the first circuit boards 4, the external interface component 32 in the interface component 3 is located on a surface of one of the first circuit boards 4, and the internal interface component 31 in the interface component 3 is located on a surface of another first circuit board 4.

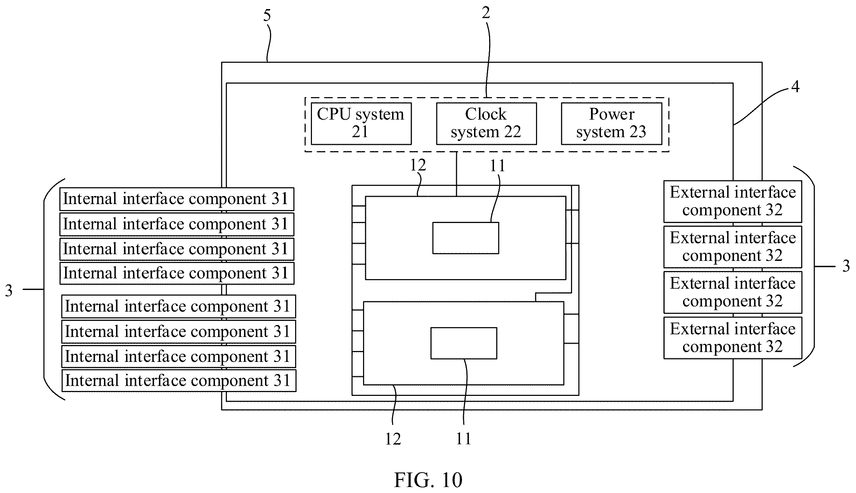

For another example, as shown in FIG. 10, there may alternatively be one first circuit board 4, and both the basic configuration 2 and the interface component 3 are arranged on a surface of a same first circuit board 4. The interface component 3 may include an internal interface component 31 and an external interface component 32, or may include only an external interface component 32, or even may include only an internal interface component 31.

As shown in FIG. 10, a mounting area that is on the first circuit board 4 and that corresponds to the main chip module 1 may be provided with a hole, so that the main chip module 1 is located in a hole area of the first circuit board 4.

Alternatively, in another solution, there may be one first circuit board 4. The basic configuration 2, the interface component 3, and the main chip module 1 may be all located on a surface of the first circuit board 4. Both the basic configuration 2 and the interface component 3 are fastened to the surface of the first circuit board 4. A lower surface of the second circuit board 12 of the main chip module 1 is electrically connected to an upper surface of the first circuit board 4, so that the main chip 11 is electrically connected to the contact configuration 2, and the main chip 11 is electrically connected to the interface component 3. Certainly, the main chip module 1 may alternatively not be located on the surface of the first circuit board 4.

It should be noted that, in some examples, some components in the basic configuration 2 may be arranged on a surface of a same first circuit board 4, or may be arranged on surfaces of different first circuit boards 4.

The foregoing provides a case in which the basic configuration 2 and the interface component 3 are arranged on the surface of the at least one first circuit board 4. How to arrange the basic configuration 2 and the interface component 3 on the surface of the at least one first circuit board 4 is not specifically limited in this embodiment.

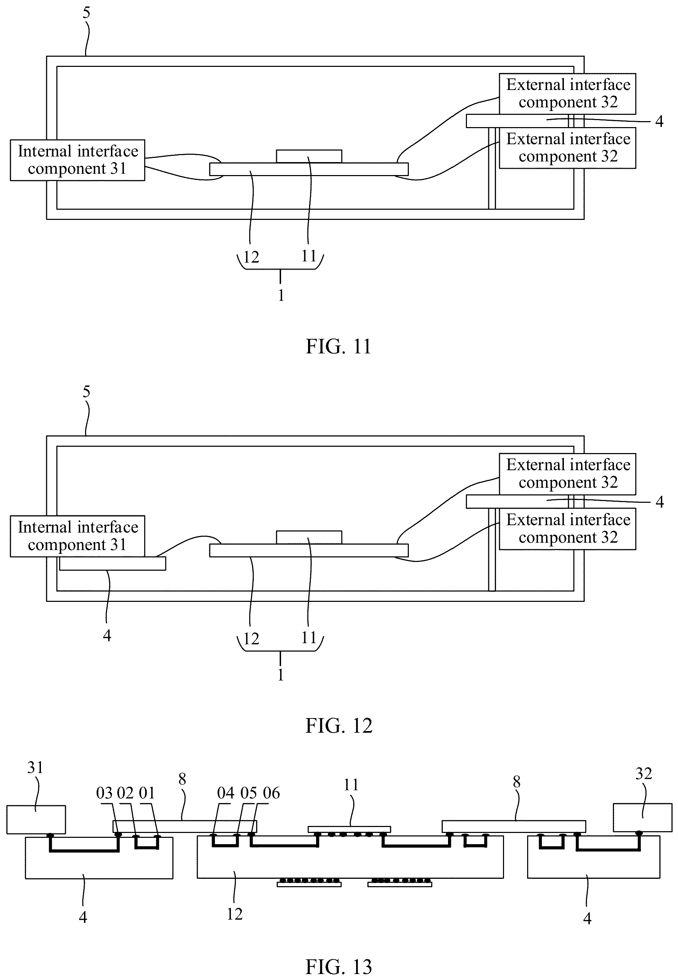

In an example, regardless of whether the board is a board of a frame-shaped communication device or a board of a box-shaped communication device, the board further includes a housing 5. As a protection board of the board, the housing 5 has functions of shielding an external signal and protecting an internal component. As shown in FIG. 11 and FIG. 12, the main chip module 1, the basic configuration 2, the interface component 3, and the first circuit board 4 are assembled in the housing 5. FIG. 11 and FIG. 12 do not show the basic configuration 2. In FIG. 11, the internal interface component 31 is directly assembled in the housing 5. In FIG. 12, the internal interface component 31 is arranged on a surface of a first circuit board 4, and is assembled in the housing 5 by using the first circuit board 4. Because the interface component 3 is configured to be connected to a component outside the board, a part of the interface component 3 is located in the housing 5, and the other part is exposed from the housing 5, for example, exposed through a port of the housing 5.

In an example, the main chip 11 of the main chip module 1 is separately electrically connected to the basic configuration 2 and the interface component 3. For example, as shown in FIG. 4, an electrical connection between the main chip 11 and the basic configuration 2 may be implemented through an electrical connection between the second circuit board 12 on which the main chip 11 is located and the first circuit board 4 on which the basic configuration 2 is located. As shown in FIG. 6, an electrical connection between the main chip 11 and the interface component 3 is also implemented through an electrical connection between the second circuit board 12 on which the main chip 11 is located and the first circuit board 4 on which the interface component 3 is located.

In another example, the main chip 11 and the basic configuration 2 may alternatively be directly electrically connected, and the main chip 11 and the interface component 3 may alternatively be directly electrically connected. For example, as shown in FIG. 4 and FIG. 5, the main chip 11 is directly electrically connected to the external interface component 32 and the internal interface component 31.

In this embodiment, whether the main chip 11 and the basic configuration 2 are directly electrically connected or electrically connected by using the circuit boards on which the main chip 11 and the basic configuration 2 are respectively located is not specifically limited, and whether the main chip 11 and the interface component 3 are directly electrically connected or electrically connected by using the circuit boards on which the main chip 11 and the interface component 3 are respectively located is not specifically limited. Several possible electrical connection implementations may be described by using an example in which the main chip 11 and the basic configuration 2 are electrically connected by using the circuit boards on which the main chip 11 and the basic configuration 2 are respectively located, and the main chip 11 and the interface component 3 are electrically connected by using the circuit boards on which the main chip 11 and the interface component 3 are respectively located.

In an electrical connection manner, the first circuit board 4 and the second circuit board 12 may be electrically connected by using a cable, for example, a copper cable.

For example, one end of the cable is electrically connected to the first circuit board 4, and the other end of the cable is electrically connected to the second circuit board 12. An implementation for separately electrically connecting the cable to the first circuit board 4 and the second circuit board 12 may be laser welding, crimping, or a connection by using an elastic conductor.

In another electrical connection manner, the first circuit board 4 and the second circuit board 12 may be electrically connected by using a flexible printed circuit (flexible printed circuit, FPC). For example, the flexible printed circuit is separately welded or crimped on surfaces of the first circuit board 4 and the second circuit board 12.

In another electrical connection manner, as shown in FIG. 13, the first circuit board 4 and the second circuit board 12 may be electrically connected by using an adapter board 8. The adapter board 8 is also a circuit board. As shown in FIG. 13, one end of the adapter board 8 is electrically connected to the first circuit board 4, and the other end of the adapter board 8 is electrically connected to the second circuit board 12. An implementation for separately electrically connecting the adapter board 8 to the first circuit board 4 and the second circuit board 12 may be welding, crimping, or a connection by using an elastic conductor.

In another electrical connection manner, as shown in FIG. 6, the second circuit board 12 may alternatively be arranged on the surface of the first circuit board 4, and the lower surface of the second circuit board 12 is directly crimped on the upper surface of the first circuit board 4, to implement the electrical connection between the first circuit board 4 and the second circuit board 12.

In an example, the electrical connection between the first circuit board 4 and the second circuit board 12 may be a detachable connection for subsequent upgrade of the main chip. For example, when the main chip is upgraded, an original main chip module may be directly removed from the board, and a new main chip module is mounted in the board. In this case, another component in the board is slightly changed or even not changed, thereby facilitating upgrade of the board.

A detachable electrical connection manner between the first circuit board 4 and the second circuit board 12 may be specifically an electrical connection implemented by using a pluggable connector. The pluggable connector may be specifically a blind-mating connector, a pogopin pogopin connector, or a crimp connector.

In some other examples, there are a plurality of electrical connections between the first circuit board 4 and the second circuit board 12. In this case, the plurality of electrical connection manners may use one or more of the foregoing electrical connection manners. For example, at least one electrical connection manner of a cable connection, a flexible printed circuit connection, an adapter board connection, and a pluggable connector connection may be used.

It can be learned that the electrical connection manner between the first circuit board 4 and the second circuit board 12 is flexible, and the electrical connection manner has strong compatibility. Further, an electrical connection manner between the main chip 11 and the basic configuration 2 and an electrical connection manner between the main chip 11 and the interface component 3 are flexible, and have strong compatibility.

The electrical connection manner between the first circuit board 4 and the second circuit board 12 is not limited in this embodiment, and may be flexibly selected.

In an example, the electrical connection between the first circuit board 4 and the second circuit board 12 may be an electrical connection between a solder ball on a first surface of the first circuit board 4 and a solder ball on a first surface of the second circuit board 12, an electrical connection between a solder ball on a second surface of the first circuit board 4 and a solder ball on a second surface of the second circuit board 12, an electrical connection between a solder ball on a first surface of the first circuit board 4 and a solder ball on a second surface of the second circuit board 12, or an electrical connection between a solder ball on a second surface of the first circuit board 4 and a solder ball on a first surface of the second circuit board 12. The first surface of the first circuit board 4 and the first surface of the second circuit board 12 are located on a same side, for example, both are upper surfaces, and the second surface of the first circuit board 4 and the second surface of the second circuit board 12 are located on a same side, for example, both are lower surfaces.

For example, the first surfaces of the first circuit board 4 and the second circuit board 12 that are located on the same side are electrically connected by using the cable, the flexible printed circuit, or the adapter board 8, as shown in FIG. 13.

For another example, the second surfaces of the first circuit board 4 and the second circuit board 12 that are located on the same side are electrically connected by using the cable, the flexible printed circuit, or the adapter board 8.

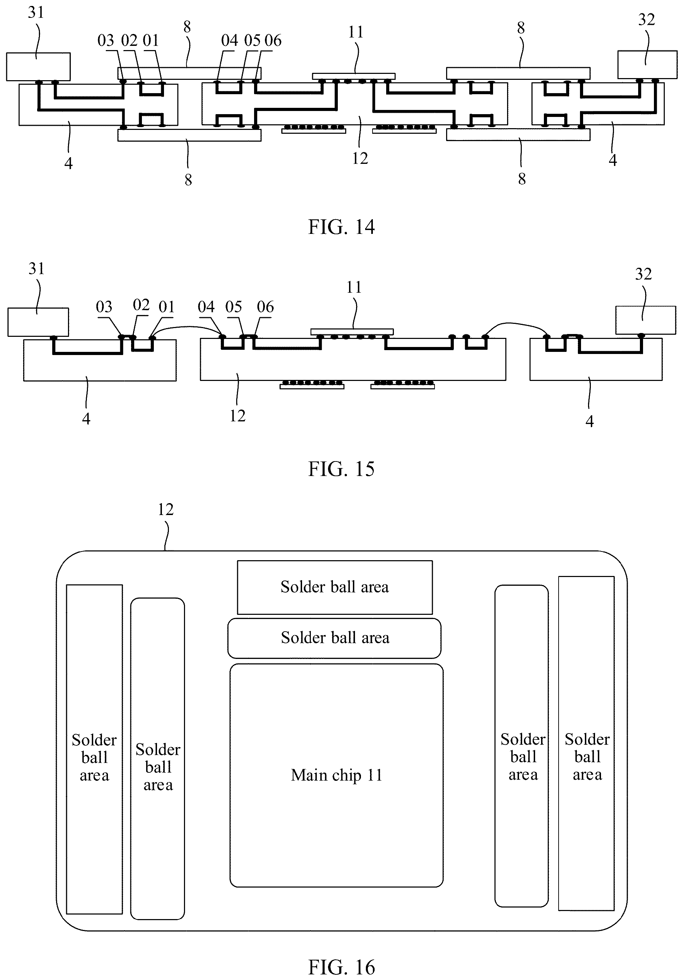

For another example, the first surfaces of the first circuit board 4 and the second circuit board 12 that are located on the same side are electrically connected by using the cable, the flexible printed circuit, or the adapter board 8, and the second surfaces located on the same side are also electrically connected by using the cable, the flexible printed circuit, or the adapter board 8, as shown in FIG. 14. In other words, two surfaces of the first circuit board 4 are electrically connected to two surfaces of the second circuit board 12.

In an example, for an electrical connection location between the first circuit board 4 and the second circuit board 12, a surface of the first circuit board 4 has a solder ball, a surface of the second circuit board 12 has a solder ball, and the two solder balls are connected by using the cable, the flexible printed circuit, or the adapter board, to implement the electrical connection between the first circuit board 4 and the second circuit board 12.

It should be noted that the electrical connection between the first circuit board 4 and the second circuit board 12 is used to implement the electrical connection between the basic configuration 2 or the interface component 3 on the first circuit board 4 and the main chip 11 on the second circuit board 12. Therefore, the solder ball that is on the surface of the first circuit board 4 and that is connected to the cable, the flexible printed circuit, or the adapter board needs to be electrically connected to the basic configuration 2 or the interface component 3, and the solder ball that is on the surface of the second circuit board 12 and that is connected to the cable, the flexible printed circuit, or the adapter board needs to be electrically connected to the main chip 11.

The cable, the adapter board 8, or the flexible printed circuit that connects the first circuit board 4 to the second circuit board 12 may be connected to any solder ball on the surface of the first circuit board 4 and any solder ball on the surface of the second circuit board 12.

For example, as shown in FIG. 13 to FIG. 15, a surface that is of the first circuit board 4 and on which the internal interface component 31 is located has a first solder ball 01, a second solder ball 02, and a third solder ball 03. The first solder ball 01 and the second solder ball 02 are electrically connected through transverse cabling inside the first circuit board 4, and the third solder ball 03 and the internal interface component 31 are electrically connected through transverse cabling inside the first circuit board 4. A surface of the second circuit board 12 has a fourth solder ball 04, a fifth solder ball 05, and a sixth solder ball 06. The fourth solder ball 04 and the fifth solder ball 05 are electrically connected through transverse cabling inside the second circuit board 12, and the sixth solder ball 06 and the main chip 11 are electrically connected through transverse cabling inside the second circuit board 12.

In a solution, as shown in FIG. 13, the first circuit board 4 and the second circuit board 12 being connected by using the adapter board 8 is used as an example. The adapter board 8 may be separately connected to the third solder ball 03 and the sixth solder ball 06. The third solder ball 03 is electrically connected to the internal interface component 31, and the sixth solder ball 06 is electrically connected to the main chip 11, to implement the electrical connection between the main chip 11 and the internal interface component 31.

In another solution, as shown in FIG. 15, the first circuit board 4 and the second circuit board 12 being connected by using the cable is used as an example. The cable may be separately electrically connected to the first solder ball 01 and the fourth solder ball 04.

As shown in FIG. 15, the first solder ball 01 that is connected to the cable and that is on the surface that is of the first circuit board 4 and on which the internal interface component 31 is located is not electrically connected to the internal interface component 31 through transverse cabling inside the first circuit board 4, but the first solder ball 01 is electrically connected to the second solder ball 02 on the surface of the first circuit board 4 through transverse cabling inside the first circuit board 4, and the third solder ball 03 on the surface of the first circuit board 4 is electrically connected to the internal interface component 31 through transverse cabling inside the first circuit board 4. In this case, to implement an electrical connection between the first solder ball 01 and the internal interface component 31, an electrical connection may be established between the second solder ball 02 and the third solder ball 03. For example, the electrical connection may be established between the second solder ball 02 and the third solder ball 03 by using a resistor, a capacitor, or crimping.

In this way, the first solder ball 01 and the second solder ball 02 are electrically connected through transverse cabling inside the first circuit board 4, the second solder ball 02 and the third solder ball 03 are electrically connected by using a resistor or a capacitor on the surface of the first circuit board 4, and the third solder ball 03 and the internal interface component 31 are electrically connected through transverse cabling inside the first circuit board 4, so that the first solder ball 01 and the internal interface component 31 have an electrical connection relationship.

Similarly, still refer to FIG. 15. The fourth solder ball 04 that is on the surface of the second circuit board 12 and that is connected to the cable is not electrically connected to the main chip 11 through transverse cabling inside the second circuit board 12, but the fourth solder ball 04 is electrically connected to the fifth solder ball 05 on the surface of the second circuit board 12 through transverse cabling inside the second circuit board 12, and the sixth solder ball 06 on the surface of the second surface 12 is electrically connected to the main chip 11 through transverse cabling inside the second circuit board 12. In this case, to implement an electrical connection between the fourth solder ball 04 and the main chip 11, an electrical connection may be established between the fifth solder ball 05 and the sixth solder ball 06. For example, the electrical connection may be established between the fifth solder ball 05 and the sixth solder ball 06 by using a resistor, a capacitor, or crimping.

In this way, the fourth solder ball 04 and the fifth solder ball 05 are electrically connected through transverse cabling inside the second circuit board 12, the fifth solder ball 05 and the sixth solder ball 06 are electrically connected by using a resistor or a capacitor on the surface of the second circuit board 12, and the sixth solder ball 06 and the main chip 11 are electrically connected through transverse cabling inside the second circuit board 12, so that the fourth solder ball 04 and the main chip 11 have an electrical connection relationship.

In this way, based on the electrical connection between the first solder ball 01 and the internal interface component 31, the electrical connection between the fourth solder ball 04 and the main chip 11, and the cable connection between the first solder ball 01 and the fourth solder ball 04, the electrical connection between the main chip 11 and the internal interface component 31 can be implemented.

In another solution, the cable, the flexible printed circuit, or the adapter board that connects the first circuit board 4 to the second circuit board 12 may alternatively be connected between the first solder ball 01 and the sixth solder ball 06, connected between the first solder ball 01 and the fifth solder ball 05, connected between the second solder ball 02 and the fourth solder ball 04, connected between the second solder ball 02 and the fifth solder ball 05, connected between the second solder ball 02 and the sixth solder ball 06, connected between the third solder ball 03 and the fourth solder ball 04, or connected between the third solder ball 03 and the fifth solder ball 05.

It can be learned that a connection location between the first circuit board 4 and the second circuit board 12 is relatively flexible, and the connection location may be flexibly selected according to an actual layout.

In an example, a solder ball is usually arranged at a location close to an edge of a circuit board. For example, as shown in FIG. 16, there is a solder ball area at a location close to a left edge of the first surface that is of the second circuit board 12 and that is assembled with the main chip 11, and the solder ball area may be configured to be electrically connected to the internal interface component 31; there is a solder ball area at a location close to a right edge, and the solder ball area may be configured to be electrically connected to an external connector 32; and there is a solder ball area at a location close to an upper edge, and the solder ball area may be configured to be electrically connected to the basic configuration 2.

Still refer to FIG. 16. The main chip 11 may be mounted on the first surface of the second circuit board 12, for example, mounted at a location close to a center of the first surface, that is, a central location of the main chip 11 is opposite to a central location of the second circuit board 12.

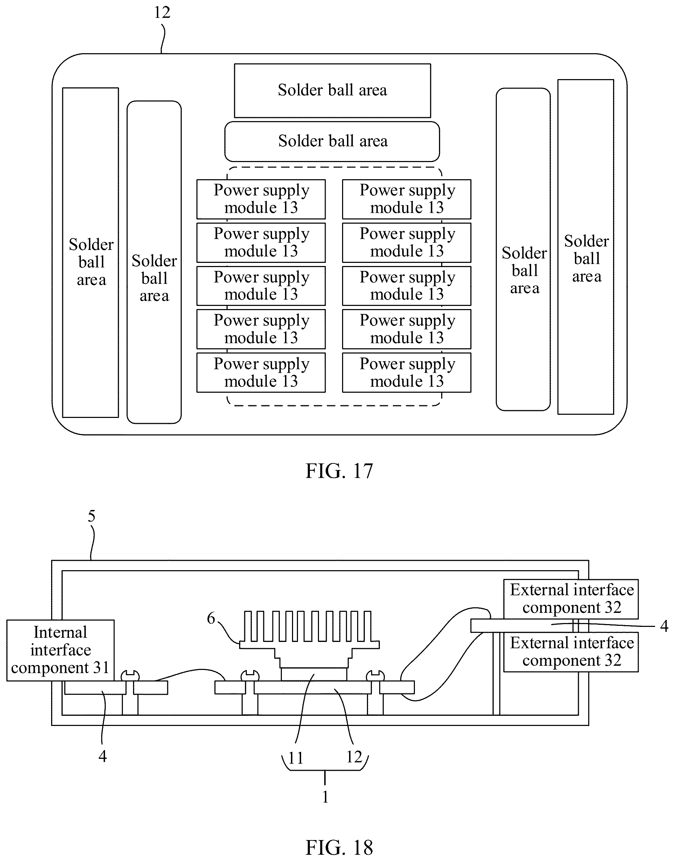

As described above, the second circuit board 12 may be electrically connected to the first circuit board 4 by using the first surface of the second circuit board 12, or may be electrically connected to the first circuit board 4 by using the second surface of the second circuit board 12. Therefore, as shown in FIG. 17, there is a solder ball at a location close to a left edge of the second surface (opposite to the first surface) of the second circuit board 12, and the solder ball may be configured to be electrically connected to the internal interface component 31; there is a solder ball at a location close to a right edge, and the solder ball may be configured to be electrically connected to the external connector 32; and there is a solder ball at a location close to an upper edge, and the solder ball may be configured to be electrically connected to the basic configuration 2.

Still refer to FIG. 17. A power supply module 13 configured to supply power to the main chip 11 may be mounted at a location that is on the second surface of the second circuit board 12 and that corresponds to the main chip 11, and the power supply module 13 may be vertically mounted on the second surface of the second circuit board 12.

In an example, as described above, the main chip 11 is electrically connected to the internal interface component 31. In a solution in which there are a plurality of main chip modules 1, the main chip 11 of each of the main chip modules 1 may be electrically connected to all the internal interface components 31, or main chips 11 of some main chip modules 1 may be electrically connected to some internal interface components 31, and main chips 11 of the remaining main chip modules 1 are electrically connected to the remaining internal interface components 31. For example, as shown in FIG. 9, there are eight internal interface components 31, and there are two main chip modules 1. In this case, the second circuit board 12 of one of the main chip modules 1 is electrically connected to four of the internal interface components 31, and the second circuit board 12 of the other main chip module 1 is electrically connected to the other four internal interface components 31.

Similarly, in a solution in which there are a plurality of main chip modules 1, the electrical connection between the main chip 11 and the external connector 32 may be that the main chip 11 of each of the main chip modules 1 is electrically connected to all the external connectors 32, or may be that main chips 11 of some main chip modules 1 are electrically connected to some external connectors 32, and main chips 11 of the remaining main chip modules 1 are electrically connected to the remaining external connectors 32. For example, as shown in FIG. 9, there are four external connectors 32, and there are two main chip modules 1. In this case, the second circuit board 12 of one of the main chip modules 1 is electrically connected to two of the external connectors 32, and the second circuit board 12 of the other main chip module 1 is connected to the other two external connectors 32.

In an example, a manner of fastening the main chip module 1 to the housing 5 may be that the second circuit board 12 of the main chip module 1 is directly fastened to the housing 5, as shown in FIG. 18. For example, as shown in FIG. 18, the second circuit board 12 is directly mounted on a bottom plate of the housing 5 by using a screw.

Still refer to FIG. 18. The first circuit board 4 on which the internal interface component 31 is located may also be directly fastened to the bottom plate of the housing 5 by using a screw. The first circuit board 4 on which the external connector 32 is located may also be directly fastened to the bottom plate of the housing 5 by using a screw.

Heights of the first circuit board 4 and the second circuit board 12 on the housing 5 may be adjusted based on a height of a limiting column inside the housing 5. Refer to FIG. 18. The height of the first circuit board 4 on which the external connector 32 is located is adjusted by using the limiting column.

In an example, because the main chip 11 needs to dissipate heat, as shown in FIG. 18, a heat sink 6 may be mounted on the second circuit board 12, and a lower surface of the heat sink 6 is attached to the main chip 11, to dissipate heat for the main chip 11.

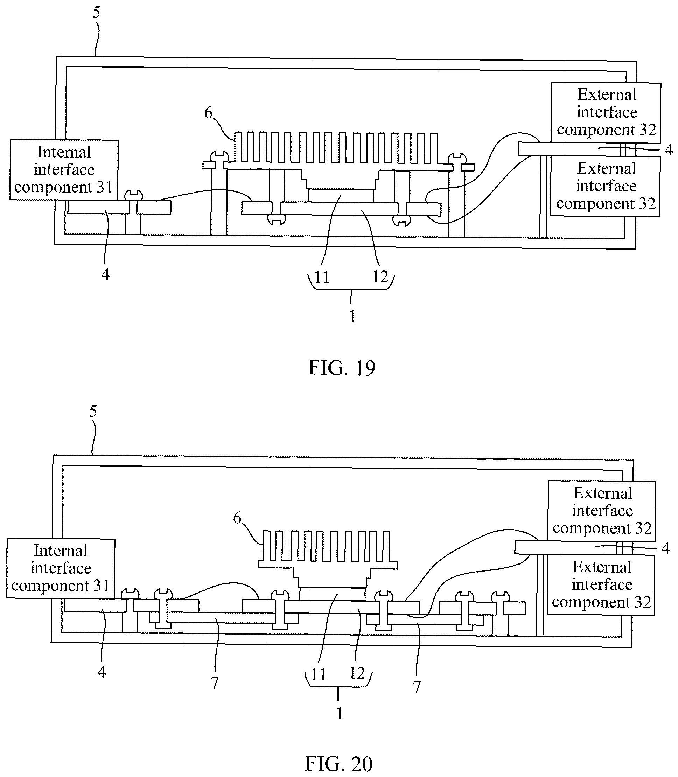

Another manner of fastening the main chip module 1 to the housing 5 may be as follows: As shown in FIG. 19, the heat sink 6 is directly fastened to the bottom plate of the housing 5, the second circuit board 12 of the main chip module 1 is underslung-mounted on the lower surface of the heat sink 6, and the main chip 11 is attached to the lower surface of the heat sink 6.

As shown in FIG. 19, a base plate of the heat sink 6 is fastened to the bottom plate of the housing 5 by using a screw, there is a spacing between the lower surface of the heat sink 6 and the bottom plate of the housing 5, the second circuit board 12 is fastened to the lower surface of the heat sink 6 by using a screw, and the main chip 11 is attached to the lower surface of the heat sink 6.

Another manner of fastening the main chip module 1 to the housing 5 may be as follows: As shown in FIG. 20, the first circuit board 4 is fastened to the housing 5 of the board, and the second circuit board 12 of the main chip module 1 is fastened to the first circuit board 4 by using a structural part 7.

For example, as shown in FIG. 20, a left side of the second circuit board 12 is close to the first circuit board 4 on which the internal interface component 31 is located, and a right side of the second circuit board 12 is close to the first circuit board 4 on which the external connector 32 is located. In this case, the left side of the second circuit board 12 is fastened to the first circuit board 4 on which the internal interface component 31 is located by using the structural part 7, and the right side of the second circuit board 12 is fastened to the first circuit board 4 on which the external connector 32 is located by using another structural part 7. The first circuit board 4 on which the internal interface component 31 is located and the first circuit board 4 on which the external connector 32 is located are both fastened to the bottom plate of the housing 5 by using screws. In this way, the second circuit board 12 is fastened to the housing 5 by using the two first circuit boards 4.

Still refer to FIG. 20. The heat sink 6 is fastened to the second circuit board 12, and the lower surface of the heat sink 6 is attached to the main chip 11.

Based on the foregoing description, the board in this embodiment includes the main chip module, the main chip module includes the main chip and the second circuit board, the main chip is located on the surface of the second circuit board, and the basic configuration and the interface component of the board are located on the surface of the at least one first circuit board. It can be learned that the main chip running at a high speed and the basic configuration and the interface component that run at a low speed are not located on a same circuit board. In this way, the first circuit board only needs to meet a running requirement of the basic configuration and the interface component, and does not need to meet a running requirement of the main chip. The second circuit board is configured to meet the running requirement of the main chip. Therefore, both the first circuit board and the second circuit board can play respective maximum values, thereby reducing resource waste. In addition, the second circuit board is processed by using a high-performance board material that is adapted to the main chip, and the first circuit board is processed by using a board material that is adapted to the basic configuration and the interface component. In this way, there is no need to use the high-performance board material to process all the circuit boards. Therefore, board material costs of the circuit boards can be reduced, and costs of the board can be reduced.

According to this embodiment, if the board needs to be configured with a plurality of main chips when the board is assembled, only a main chip module including a plurality of main chips or a plurality of main chip modules need to be mounted without developing a main board that can be configured with a plurality of main chips, thereby reducing development costs of the main board, and facilitating cost control of the board.

When the main chip of the board is upgraded, only the second circuit board on which the main chip is located needs to be upgraded, thereby controlling upgrade costs of the circuit board.

During board assembly, the main chip module and the first circuit board may be flexibly matched. For example, the main chip module may be matched with first circuit boards of different specifications or sizes to form the board. For another example, the first circuit board may alternatively be matched with different main chip modules to form a board, thereby improving board assembly flexibility.

Different main chip modules may refer to including different main chips or including different quantities of main chips. Different main chips may refer to main chips of different types, or main chips of a same type but with different sizes or capacities.

Because the main chip of the board and the circuit board on which the main chip is located form an independent module, any possible electrical connection manner may be used for an electrical connection between the main chip and another component, so that flexibility of an electrical connection manner between the main chip and a peripheral circuit can be enhanced.

This embodiment further provides a board assembly method, where the board is the foregoing board. The method may include: fastening the basic configuration 2 and the interface component 3 to the surface of the at least one first circuit board 4. For example, the basic configuration 2 and the interface component 3 are arranged on a surface of a same first circuit board 4. For another example, the basic configuration 2 is arranged on a surface of one first circuit board 4, and the interface component 3 is arranged on a surface of another first circuit board 4. For another example, the basic configuration 2 and the internal interface component 31 are arranged on a surface of a same first circuit board 4, and the external interface component 32 is arranged on a surface of another first circuit board 4. For another example, the basic configuration 2 and the external interface component 32 are arranged on a surface of a same first circuit board 4, and the internal interface component 31 is arranged on a surface of another first circuit board 4. For another example, the basic configuration 2 is arranged on a surface of one first circuit board 4, the internal interface component 31 is arranged on a surface of one first circuit board 4, and the external interface component 32 is arranged on a surface of another first circuit board 4.

After the basic configuration 2 and the interface component 3 are mounted on the surface of the at least one first circuit board 4, the at least one first circuit board 4 may be fastened to the housing 5 of the board, for example, may be fastened to the bottom plate or an upper cover of the housing 5 by using a screw.

The main chip module 1 is also fastened to the housing 5 of the board. For example, the second circuit board of the main chip module is directly fastened to the bottom plate or the upper cover of the housing 5. For another example, the second circuit board of the main chip module is underslung-mounted on the lower surface of the heat sink, and the heat sink is fastened to the bottom plate or the upper cover of the housing 5. The main chip 11 is attached to the lower surface of the heat sink 6. For another example, the second circuit board of the main chip module is fastened to the first circuit board 4 by using the structural part 7, and the first circuit board 4 is fastened to the housing 5.

The main chip 11 of the main chip module 1 is separately electrically connected to the basic configuration 2 and the interface component 3. For example, the main chip 11 is directly connected to the basic configuration 2 by using a cable, a flexible printed circuit, or an adapter board, and the main chip 11 is directly connected to the interface component 3 by using a cable, a flexible printed circuit, or an adapter board. For another example, the second circuit board on which the main chip 11 is located is electrically connected to the first circuit board on which the basic configuration 2 is located, to implement an electrical connection between the main chip 11 and the basic configuration 2, and the second circuit board on which the main chip 11 is located is electrically connected to the first circuit board on which the interface component 3 is located, to implement an electrical connection between the main chip 11 and the interface component 3.

In this embodiment, the board includes the main chip module, the main chip module includes the main chip and the second circuit board, the main chip is located on the surface of the second circuit board, and the basic configuration and the interface component of the board are located on the surface of the at least one first circuit board. It can be learned that the main chip running at a high speed and the basic configuration and the interface component that run at a low speed are not located on a same circuit board. In this way, the first circuit board only needs to meet a running requirement of the basic configuration and the interface component, and does not need to meet a running requirement of the main chip. The second circuit board is configured to meet the running requirement of the main chip. Therefore, both the first circuit board and the second circuit board can play respective maximum values, thereby reducing resource waste. In addition, the second circuit board is processed by using a high-performance board material that is adapted to the main chip, and the first circuit board is processed by using a board material that is adapted to the basic configuration and the interface component. In this way, there is no need to use the high-performance board material to process all the circuit boards. Therefore, board material costs of the circuit boards can be reduced, and costs of the board can be reduced.

An embodiment further provides a communication device. The communication device includes the foregoing board. The communication device may be a router or a switch. An architecture of the communication device may be a frame-shaped communication device, or may be a box-shaped communication device.

The foregoing descriptions are merely an embodiment of the present disclosure, but are not intended to limit the present disclosure. Any modification, equivalent replacement, or improvement made without departing from the spirit and principle of the present disclosure shall fall within the protection scope of the present disclosure.

## Claims

1. A board, wherein the board comprises a main chip module (1), a basic configuration (2), an interface component (3), and a first circuit board (4);
the main chip module (1) comprises a main chip (11) and a second circuit board (12), and the main chip (11) is located on a surface of the second circuit board (12);
there is at least one first circuit board (4), and the basic configuration (2) and the interface component (3) are located on a surface of the at least one first circuit board (4); and
the main chip (11) is separately electrically connected to the basic configuration (2) and the interface component (3).

2. The board according to claim 1, wherein the second circuit board (12) is electrically connected to the at least one first circuit board (4).

3. The board according to claim 2, wherein an electrical connection manner between the second circuit board (12) and the first circuit board (4) comprises at least one of a connection by using a cable, a connection by using a flexible printed circuit, a connection by using a pluggable connector, and a connection by using an adapter board.

4. The board according to any one of claims 1 to 3, wherein there is one first circuit board (4), and the basic configuration (2) and the interface component (3) are located on a surface of a same first circuit board (4).

5. The board according to any one of claims 1 to 3, wherein there are a plurality of first circuit boards (4), and the basic configuration (2) and the interface component (3) are located on surfaces of different first circuit boards (4).

6. The board according to any one of claims 1 to 3 or 5, wherein the interface component (3) comprises an external interface component (32) and an internal interface component (31); and
there are at least two first circuit boards (4), the external interface component (32) is located on a surface of one of the first circuit boards (4), and the internal interface component (31) is located on a surface of the other first circuit board (4).

7. The board according to any one of claims 1 to 6, wherein the second circuit board (12) of the main chip module (1) is fastened to a housing (5) of the board.

8. The board according to any one of claims 1 to 6, wherein the second circuit board (12) of the main chip module (1) is underslung-mounted on a lower surface of a heat sink (6) of the board, and the heat sink (6) is fastened to a housing (5) of the board.

9. The board according to any one of claims 1 to 6, wherein the first circuit board (4) is fastened to a housing (5) of the board, and the second circuit board (12) of the main chip module (1) is fastened to the first circuit board (4) by using a structural part (7).

10. A board assembly method, wherein the board is the board according to any one of claims 1 to 9, and the method comprises:
fastening the basic configuration (2) and the interface component (3) to the surface of the at least one first circuit board (4);
fastening the main chip module (1) and the at least one first circuit board (4) to the housing (5) of the board; and
separately electrically connecting the main chip (11) of the main chip module (1) to the basic configuration (2) and the interface component (3).

11. The method according to claim 10, wherein fastening the main chip module (1) to the housing (5) of the board comprises fastening the second circuit board (12) of the main chip module (1) to the housing (5) of the board.

12. The method according to claim 10, wherein fastening the second circuit board (12) of the main chip module (1) to the housing (5) of the board comprises:
fastening the second circuit board (12) of the main chip module (1) to the lower surface of the heat sink (6), wherein the main chip (11) of the main chip module (1) is located between the heat sink (6) and the second circuit board (12); and
fastening the heat sink (6) to the housing (5) of the board.

13. The method according to claim 10, wherein fastening the second circuit board (12) of the main chip module (1) and the at least one first circuit board (4) to the housing (5) of the board comprises:
fastening the second circuit board (12) of the main chip module (1) to the at least one first circuit board (4) by using the structural part (7); and
fastening the at least one first circuit board (4) to the housing (5) of the board.

14. A communication device, wherein the communication device comprises the board according to any one of claims 1 to 9.
